(19) Europäisches Patentamt
European Patent Office
Office européen des brevets

(11) **EP 4 195 503 A1**

(12) **EUROPEAN PATENT APPLICATION**

(43) Date of publication:
**14.06.2023 Bulletin 2023/24**

(21) Application number: **23150187.5**

(22) Date of filing: **13.04.2018**

(51) International Patent Classification (IPC):
*H03F 1/32* (2006.01)    *H03F 3/24* (2006.01)
*H04B 3/23* (2006.01)    *H03F 3/189* (2006.01)
*H03F 3/21* (2006.01)

(52) Cooperative Patent Classification (CPC):
**H03F 1/3247; H03F 1/3241; H03F 1/3252;**
**H03F 3/189; H03F 3/211; H03F 3/24; H04B 3/23;**
H03F 2200/451

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(62) Document number(s) of the earlier application(s) in
accordance with Art. 76 EPC:
**18167347.6 / 3 553 947**

(71) Applicant: **MaxLinear Asia Singapore Private**
**Limited**
**Singapore (SG)**

(72) Inventors:
• KOL, Boaz
  **4536011 Hod-Hasharon (IL)**
• ZUKUNFT, Roland
  **85521 Ottobrunn (DE)**

(74) Representative: **2SPL Patentanwälte PartG mbB**
**Landaubogen 3**
**81373 München (DE)**

Remarks:
This application was filed on 03.01.2023 as a
divisional application to the application mentioned
under INID code 62.

(54) **SYSTEM AND METHOD FOR POWER AMPLIFIER LINEARIZATION WITH ECHO CANCELATION CAPABILITIES**

(57)    A system for power amplifier linearization comprises a power amplifier configured to amplify a transmit signal; a digital-to-analog converter configured to convert the transmit signal to an analog domain; a coupler for coupling the transmit signal after amplifying by the power amplifier to a transmit port; a signal cancelation system for canceling a linear component of the transmit signal from the feedback signal in an analog domain; an analog-to-digital converter for converting the feedback signal after canceling the linear component of the transmit signal to a digital domain; an echo cancelation filter for generating an echo cancelation signal either from the feedback signal after canceling the linear component of the transmit; and a subtractor for subtracting the echo cancelation signal from the receive signal in a digital domain.

FIG. 3

## Description

## Field

Examples relate to a power amplifier, more particularly a system and method for power amplifier linearization with echo cancelation capabilities.

## Background

A power amplifier in a transmitter is generally non-linear. Therefore, some distortion is generated, which limits the signal-to-noise ratio (SNR) of the transmit signal. Furthermore, some out-of-band emission is generated by the transmit signal. A part of this emission is reflected by a network and received at the transmitter as echo. This non-linear echo can reduce the SNR of the received signal. Conventional methods to reduce the non-linear distortion have a disadvantage that they require a very accurate analog-to-digital converter (ADC) to estimate the signal after the power amplification.

## Brief description of the Figures

Some examples of apparatuses and/or methods will be described in the following by way of example only, and with reference to the accompanying figures, in which

Fig. 1 shows an example system including power amplifier linearization and non-linear echo cancelation;

Fig. 2 shows an example Data Over Cable Service Interface Specification (DOCSIS) network;

Fig. 3 is a block diagram of an example system for power amplifier linearization;

Fig. 4 shows an alternative example system with an analog band-stop filter in the feedback path;

Fig. 5 shows an example structure of the band-stop filter;

Fig. 6 shows another example system for power amplifier linearization; and

Fig. 7 shows an example system with multiple power amplifiers and transmit chains.

## Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

The problems caused by the non-linear transfer characteristics of a power amplifier may be solved by using an amplifier that can run in a linear region and therefore introduce only a small amount of in- and out-of-band distortion. This can be achieved by using an amplifier that is capable of transmitting more power or has a wider linear region. For example, an amplifier which has a higher saturation voltage, an amplifier structure with intrinsic high linearity like Class-A, an amplifier utilizing ultra-high speed components with minimal parasitic elements, or multiple band-limited amplifiers, each servicing a portion of the transmitted spectrum may be used.

However, using an amplifier that can run in a linear region would increase the power consumption and result in a more complex and expensive system. Amplifiers with increased linearity usually also have a bigger form factor and require a higher supply voltage and sometimes also special cooling. The requirement of a highly linear power amplifier also decreases the flexibility to replace the power amplifier.

Alternatively, the power amplifier can be linearized in a digital domain. This is referred to as "linearization" or "digital predistortion." The calculation of the parameters of the linearization device requires measurement of the output signal of the power amplifier with high accuracy and thus mandates the implementation of a dedicated high bandwidth, low distortion analog-to-digital receive path. Power amplifier linearization usually requires implementation of a dedicated highly accurate ADC to estimate and track the output signal of the power amplifier with sufficient accuracy. Implementation of such an accurate ADC increases the complexity, cost and power consumption. Linearization requires very high effort in terms of area and complexity of the training algorithms if the non-linearities have to be reduced in such a way that non-linear echoes are sufficiently suppressed.

Alternatively, a non-linear echo canceller can be implemented. This technique can be used to increase the SNR of the received signal. It may be combined with one of the previously mentioned techniques to increase the SNR of the transmit signal.

A non-linear echo canceller, however, only solves the problem that non-linear echo reduces the SNR of the received signal. If the power amplifier is not linearized, it still has to be run in a region where its transfer function is relatively linear, i.e. not in a power efficient way. In addition, a non-linear echo canceller is limited in performance by a number of reasons. It mimics the non-linearity with a model, which has in general a limited number of parameters. The parameters can only be estimated with limited accuracy. It cannot model the transmitter noise e.g. the noise that is generated by a digital-to-analog converter (DAC) or a power amplifier.

Alternatively, if the requirements of the communication system do not specify a lower bound for the transmit SNR, one can, in general, run a transmission system with limited performance without solving this problem. However, a communication system that does not mandate a particular minimum transmit SNR does not make use of the link capacity and will usually not be competitive.

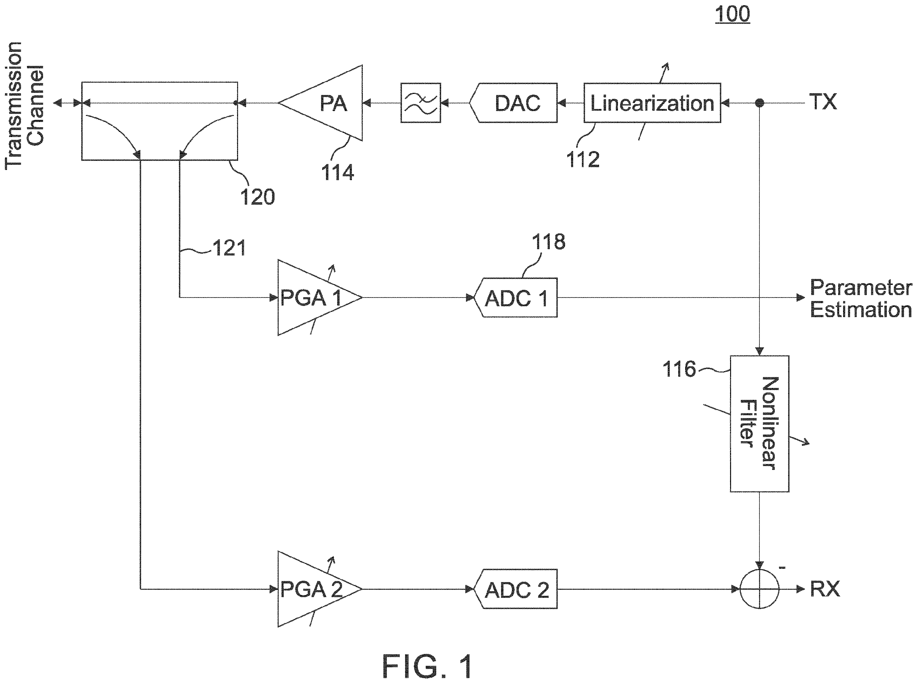

Fig. 1 shows an example system 100 including power amplifier linearization and non-linear echo cancelation. The system 100 includes a linearization device for linearization of a power amplifier 114 and a non-linear echo canceller 116. A portion of the transmit signal is tapped off at the coupler 120 to a feedback chain and the feedback signal 121 is converted to a digital domain by an ADC 118. The output digital signal is used for parameter estimation for the linearization device 112. The system 100 also includes a non-linear filter 116 for echo cancelation in a receive chain. The system 100 combines the power amplifier linearization with a non-linear echo cancelation. The system 100 has a disadvantage that it requires a very accurate ADC 118 to generate the training signal for the linearization device 112 and that the SNR of the received signal is reduced by the transmitter noise that is received via an echo path.

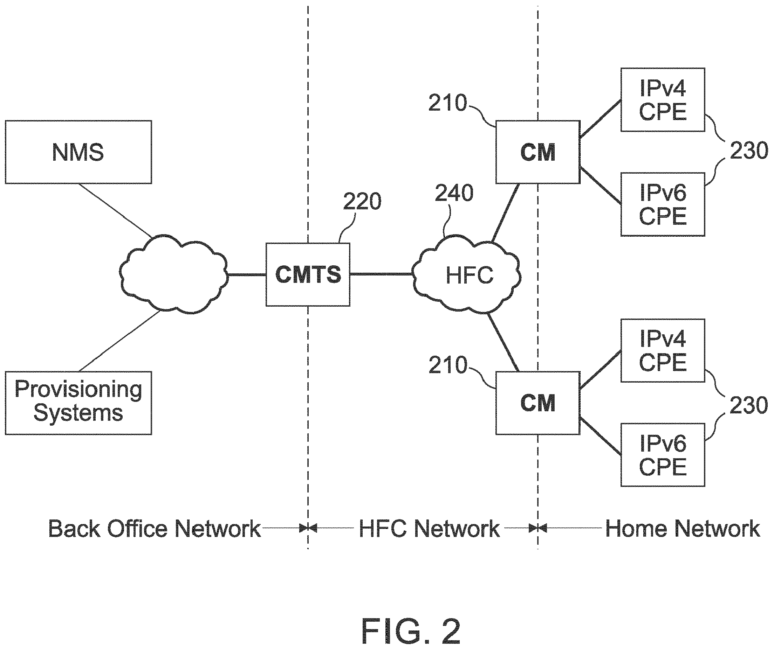

Fig. 2 shows an example Data Over Cable Service Interface Specification (DOCSIS) network. The cable modem (CM) 210 connects to the operator's hybrid fiber coax (HFC) network 240 and to a home network, bridging packets between them. Customer premise equipments (CPEs) 230 are connected to a cable modem 210. A CPE 230 may be embedded in the cable modem 210 in a single device or they may be separate. Examples of a CPE 230 include a gateway, a home router, a set-top box (STB), a personal computer, etc. The cable modem termination system (CMTS) 220 connects the operator's back office and core network to the HFC network 240. The CMTS 220 forwards packets between these two domains and between upstream and downstream channels on the HFC network.

The DOCSIS standards for the next generation HFC technology will be based on full duplex (FDX). DOCSIS FDX will allow downstream and upstream transmissions to use the same radio frequency (RF) spectrum at the same time to increase the spectral efficiency in a cable network. As the downstream and upstream spectrums overlap in time and frequency in FDX, interference would occur between transmissions and receptions.

In order to implement FDX in a cable network, cable modems may be partitioned into interference groups. An interference group is a set of cable modems in which upstream and downstream signals of cable modems interfere with each other. Once interference groups have been identified the head-end (i.e. the CMTS 220) can schedule full duplex upstream and downstream packets to the cable modems so that they do not collide in time and frequency.

While a cable network operates in FDX, a cable modem in the FDX-mode cable network may operate on separate frequency bands for upstream and downstream (i.e. in a frequency division duplex (FDD) mode) to avoid upstream interference to downstream in an FDX band. A cable modem usually does not have dedicated filters or duplexers to protect a downstream channel from the high power upstream transmissions due to the very high cost of such devices and network capacity loss due to guard bands that filters would require.

Although a cable modem operates in FDD, upstream transmit power levels are significantly higher compared to the downstream received power levels. Part of the upstream signals leaks into the downstream data path with the level of isolations available with current components (directional couplers). In addition to that, a cable modem also gets reflections of the upstream signals from the HFC path coming back to the cable modem with considerable power levels.

In examples, an echo canceller is included in a device to subtract the linear component of the transmit signal from the feedback signal, which is used to calculate the coefficients of the linearization device. This allows sampling the feedback signal with an ADC whose dynamic range is increased. The examples also provide methods to regenerate the subtracted linear component of the transmit signal in a digital domain, and the signal after subtraction of the linear component of the transmit signal can be used to suppress the remaining non-linear echo signal in the receive path.

By increasing the dynamic range of the ADC, the examples allow to implement a smaller and less power-consuming ADC, which is used to train the linearization device of the power amplifier. By the combination of linearization and cancelation of the remaining non-linear echo, it is possible to implement linearization in a cost and power efficient way as the linearization device, which is running at a very high rate, needs to reduce the non-linear component of the transmit signal such that requirements set up by a standardized transmission technology need to be fulfilled. Residual non-linear echo in the receive signal may be cancelled in the digital domain by a linear filter that runs at a much lower rate.

In some examples, a power amplifier in a device (e.g. a cable modem) is linearized in the digital domain and the remaining non-linearities, which are received via an echo path, may be removed by an echo canceller. The examples provide a method of reception and processing of the power amplifier output signal that is required to configure the linearization device for the power amplifier.

Linearization is performed, since a power amplifier, in general, has a nonlinear transfer function. These nonlinearities cause generation of distortion in the transmit signal, which are located inside and outside the transmit band. The components which are located inside the transmit band reduce the SNR of the transmit signal. Emissions outside the transmitted band might be received by other devices and reduce the SNR of the receive signal. Some portion of the transmitted distortion may be reflected by some components of the physical channel and be received by the same device and limit the SNR of the received signal.

One way to mitigate the non-linear distortion of the power amplifier is to linearize the power amplifier transfer function in a digital domain by a linearization device. The linearization device is a digital non-linear component, which distorts the transmit signal such that the output of the power amplifier becomes as linear as possible. This technique is also called digital predistortion.

The main reason to linearize the power amplifier is to enable it to operate closer to saturation, which usually leads to substantial power savings. It might also enable the usage of a smaller and therefore cheaper power amplifier. The non-linear distortion needs to be reduced at least by an amount that is sufficient to fulfill requirements for a transmit SNR and out-of-band emissions defined by the corresponding standards. A further reduction increases the number of coefficients required in the linearization device, which increases complexity and power consumption and might lead to difficulties to train the coefficients appropriately. Therefore, the transmit signal will still have a small non-linear component in practice. As some portion of the transmit signal is reflected in the cable network and received as an echo signal by the same device, a non-linear echo component will be included in the receive signal. Apart from that, it also includes a transmitter noise, which is generated by, for example, the DAC or other devices in the transmit chain. The non-linear echo together with the echoed noise might still limit the SNR of the receive signal. These echo components may be removed by an echo canceller from the receive signal.

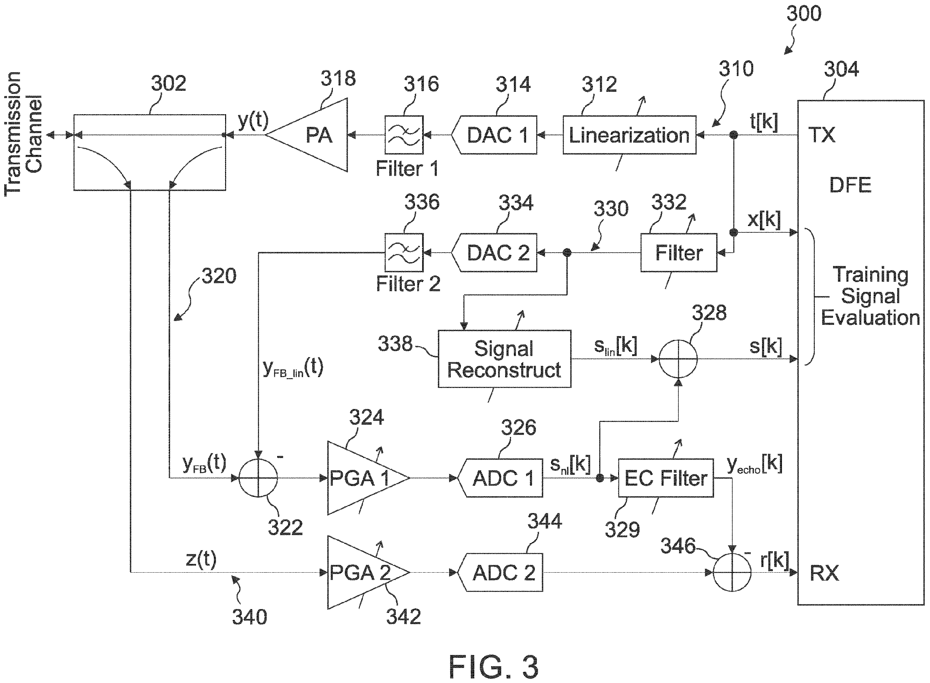

Fig. 3 is a block diagram of an example system 300 for power amplifier linearization. The system 300 may be included in a cable modem, a user equipment, etc. The system 300 may include analog components and digital components. The system 300 may be included in an analog front end (AFE). The system 300 includes an interface to a digital front end (DFE) 304 and to a coupling device 302 that is connected to a transmission channel, for example a coaxial cable. It should be noted that some components in Fig. 3 may be moved to a DFE 304 or some components may be moved from the DFE 304 to the system 300.

The input and output signals at a digital interface to the DFE 304 are denoted as $t[k]$ and $r[k]$, and the input and output signals to and from the coupling device 302 are denoted as $y(t)$ and $z(t)$, respectively. A portion of the output signal $y(t)$ is coupled back to the system 300. This signal (a feedback signal) is denoted as $y_{FB}(t)$ and is used for system adaptation as well as for echo cancelation. Fig. 3 also shows two training signals $x[k]$ and $s[k]$, which may be transferred to the DFE 304 and applied to adjust the system 300 to the current conditions.

The system 300 may include four separate signal chains. The first chain is a transmit chain 310 that processes a transmit signal. A digital transmit signal $t[k]$ is sent to a linearization device 312 (e.g. a digital predistortion device) and then converted to an analog domain by a DAC 314. Images of the transmit signal are removed by an anti-aliasing filter 316. The resulting signal is then amplified by a power amplifier 318. The linearization device 312 is provided to linearize the transfer function of the power amplifier 318. The linearization device 312 may further approximately invert the transfer function of the anti-aliasing filter 316 by an additional pre-emphasis filter function in the band of interest.

The second chain is a feedback chain 320. The feedback chain 320 is to reconstruct the transmit signal $y(t)$. The input of the feedback chain is $y_{FB}(t)$. A linear component of the transmit signal ($y_{FB\_lin}(t)$) is subtracted by a subtractor 322 (e.g. a coupler) from the feedback signal $y_{FB}(t)$ in an analog domain. The resulting signal is then amplified by a programmable gain amplifier (PGA) 324 and converted to a digital domain by an ADC 326 to generate a non-linear component of the transmit signal ($s_{nl}[k]$) in a digital domain. A linear component of the transmit signal ($s_{lin}[k]$) is reconstructed by a signal reconstruction filter 338 and added by an adder 328 to the non-linear component of the transmit signal ($s_{nl}[k]$) to form the signal $s[k]$, which is a digital reconstruction of the transmit signal $y(t)$. The digital reconstruction of the transmit signal ($s[k]$) is used to train the linearization device 312. The reconstructed non-linear component of the transmit signal $s_{nl}[k]$ may be applied to an echo cancelation filter 329 to generate a non-linear echo component of the receive signal denoted as $y_{echo}[k]$, which may be subtracted from the received signal.

The third chain is a linear signal processing chain 330, which is fed by the digital transmit signal $t[k]$. In the linear signal processing chain 330, the digital transmit signal $t[k]$ is filtered by a filter 332 (e.g. a linear filter), converted to an analog domain by a DAC 334, filtered by an anti-aliasing filter 336, and the output is subtracted by the subtractor 322 from the feedback signal $y_{FB}(t)$. Similar to the transmit chain 310, a digital pre-emphasis filter may be applied in addition to invert the transfer function of the anti-aliasing filter 336 in the band of interest. This pre-emphasis filter may be included in the filter 332.

The linear signal processing chain 330 is provided to remove/reduce the linear component of the transmit signal before the ADC 326 in the feedback chain 320 in order to increase the resolution of the quantized signal by the ADC 326 in the feedback chain. An alternative way to reduce the linear component of the transmit signal is to apply a band-stop filter in the feedback chain 320, which will be described in detail later.

The fourth chain is a receive chain 340, in which the receive signal $z(t)$ is amplified by a PGA 342 and converted to a digital domain by an ADC 344. The reconstructed echo signal may be subtracted by a subtractor 346 from the receive signal to form $r[k]$. Similar to the feedback chain 320, the linear component of the transmit signal in $z(t)$ may be estimated and subtracted in an analog domain.

The transmit signal $y(t)$ that is output from the power amplifier 318 includes a linear component and a residual non-linear component of the transmit signal $t[k]$ as well as noise. The linear component of the transmit signal $t[k]$ may be obtained by a linear processing of the transmit signal $t[k]$ with a linear filter, for example by linear combination of the transmit signal, multiplication of a constant(s), etc. The noise may be added by several components in the transmit chain, such as the DAC 314. The transmit signal $y(t)$ can be used for linear and non-linear echo cancellation and can be used to cancel some portion of the transmitter noise that is received via an echo channel. A portion of the transmit signal $y(t)$ is coupled back to the feedback chain 320 of the system 300 and converted to a digital signal by the ADC 326. The ADC 326 may sample the non-linear component of the transmit signal and the transmitter noise. The linear component of the transmit signal is already known to the DFE 304 and does not have to be sampled again. Therefore, the linear component of the transmit signal may be removed from the feedback signal in an analog domain before being sampled by the ADC 326. Since the sum of the non-linear component and the noise are usually much smaller compared to the linear component, this allows increasing the gain of the PGA 324 whereby reducing the level of quantization noise added to the feedback signal.

In order to train the linearization device 312, the power amplifier output signal may be fed back. Therefore, the filtered linear component of the transmit signal may be added to the feedback signal in a digital domain. The signal reconstruction filter 338 may be used to reconstruct the transfer function between the DAC 334 and the adder 328 after the ADC 326. The output of the filter 332 is processed by the signal reconstruction filter 338 and the output is added by an adder 328 to the feedback signal after the ADC 326. The resulting signal (after the adder 328) may be applied for training of the linearization device 312. If the DAC 334 and the ADC 326 operate at different rates, the signal reconstruction filter 338 may include a rate conversion module.

The non-linear component of the transmit signal (i.e. after cancelation of the linear component of the transmit signal from the feedback signal) may then be applied to the echo cancelation filter 329 to generate an echo cancelation signal. The echo cancelation signal that is output from the echo cancelation filter 329 is subtracted by the subtractor 346 from the receive signal in a receive chain 340. This may be sufficient in an environment where upstream and downstream signals are transmitted in separate frequency bands. In this case the signal reconstruction filter 338 may be implemented with a digital signal processor and filtering may be performed during training of the linearization device 312.

The system 300 has several advantages compared to the system 100 shown in Fig. 1. In the system 300, the overall power and complexity is reduced, even though it requires an extra DAC 334, since the high-end ADC 118 required for the system 100 can be replaced by an ADC 326 with less demanding properties. The performance of the echo canceller structure shown in Fig. 3 is also superior to the one shown in Fig. 1 since it can cancel echoes of the analog transmitter noise as well.

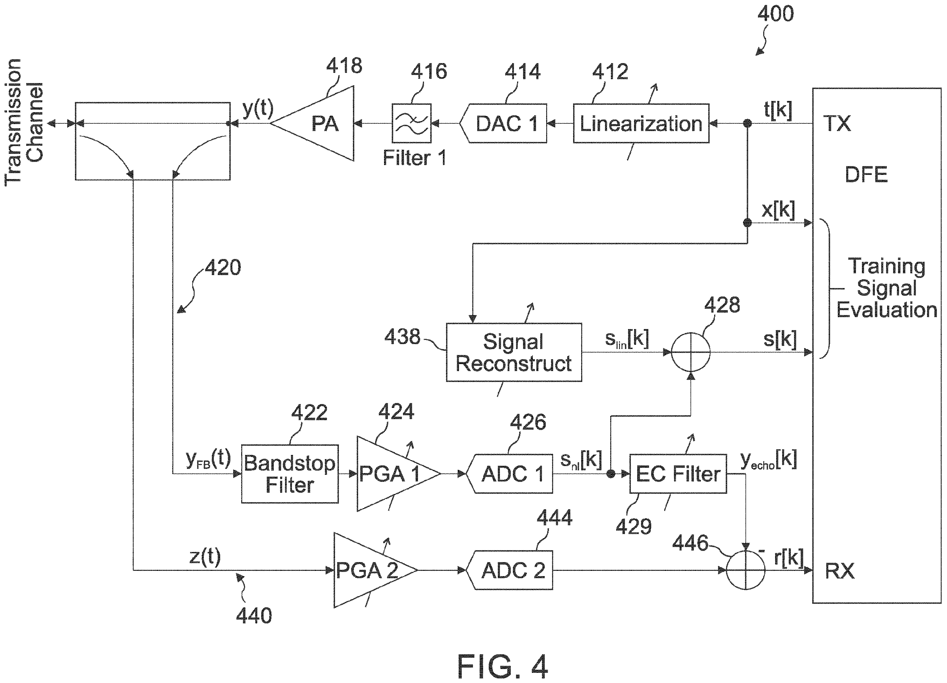

Fig. 4 shows an alternative example system 400 with an analog band-stop filter in the feedback path. The system 400 has generally the same structure as the system 300. A digital transmit signal $t[k]$ is sent to a linearization device 412 and then converted to an analog domain by a DAC 414. Images of the transmit signal are removed by an anti-aliasing filter 416. The resulting signal is then amplified by a power amplifier 418. The linearization device 412 is provided to linearize the transfer function of the power amplifier 418. The linearization device 412 may further approximately invert the transfer function of the anti-aliasing filter 416 by an additional pre-emphasis filter function in the band of interest.

A feedback chain 420 is provided to reconstruct the transmit signal $y(t)$. The input of the feedback chain is $y_{FB}(t)$. As an alternative to using the filter 332 in Fig. 3 (and the DAC 334 and the anti-aliasing filter 336) to suppress the linear component of the transmit signal, one or several analog band-stop filters 422 may be used to filter the linear component of the transmit signal in the feedback chain 420. If the transmit and receive frequency bands are configurable, (e.g. as in DOCSIS 3.1 FDX), a number of switchable or configurable analog filters may be used. After processing through the band-stop filter 422, the resulting signal is then amplified by a PGA 424 and converted to a digital domain by an ADC 426 to form a non-linear component of the transmit signal ($s_{nl}[k]$) in a digital domain. Similar to the system 300 in Fig. 3, a signal reconstruction filter 438 is provided to reconstruct the linear component of the transmit signal in a digital domain, which was cancelled by the band-stop filter 422, and the reconstructed linear component of the transmit signal is added by an adder 428 to the feedback signal (after processing through the band-stop filter 422) in a digital domain. The combined signal ($s[k]$) is used to train the linearization device 412. The combined signal $s[k]$ is different to the one shown in Fig. 3, since only the linear component of the signal component that is compressed by the analog filter is reconstructed. The non-linear component of the transmit signal $s_{nl}[k]$ may be applied to the echo cancelation filter 429 to generate an echo cancelation signal $y_{echo}[k]$, which may be subtracted from the received signal.

The band-stop filter 422 may be implemented in the form $H_{bandstop}(f) = 1 - H_{bandpass}(f)$, i.e. the linear component of the transmit signal may be extracted by means of a bandpass filter and then subtracted from the original feedback signal.

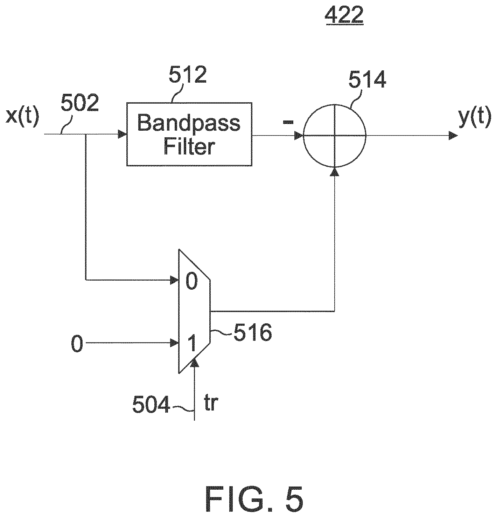

Fig. 5 shows an example structure of the band-stop filter 422. The band-stop filter 422 may be implemented with a band-pass filter 512, an adder 514, and a multiplexer 516. The band-pass filter 512 passes a specific frequency band of the input signal 502. The signal 'tr' 504 controls the output of the multiplexer 516 to be either the input signal 502 or '0.' The signal 'tr' 504 is set to 0 to implement the band-stop filter. In this case, the bandpass filter output is subtracted from the input signal 502, which generates the band-stop filter output. The filter shown in Fig. 5 can also be configured as a band-pass filter by setting the signal 'tr' 504 to 1. This configuration may be useful for training of the signal reconstruction filter, which will be explained in detail later.

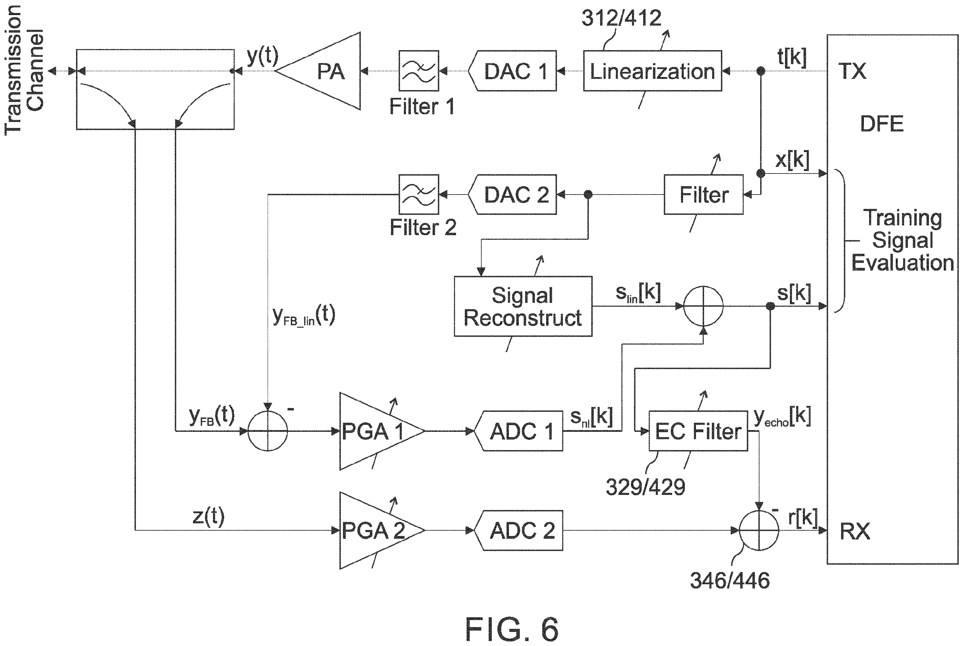

Fig. 6 shows another example system for power amplifier linearization. In the systems 300, 400 shown in Figs. 3 and 4, the non-linear component of the feedback signal (i.e. after cancelation of the linear component of the transmit signal from the feedback signal in an analog domain) is applied to the echo cancelation filter 329, 429 to generate an echo cancelation signal that is subtracted by a subtractor 346, 446 from the receive signal in a receive chain 340, 440. If upstream and downstream signals are overlapping in frequency, then the linear echo component of the transmit signal may also be cancelled from the received signal. In one example, this linear echo component of the transmit signal may be removed before an ADC 344, 444 in order to increase the signal resolution and to reduce the quantization noise. In some examples, the echo cancelation filter 329 (or 429 in Fig. 4) may be fed with the reconstructed signal $s[k]$, (i.e. the same signal that is applied to determine the parameters of the linearization device 312, 412) to generate the echo cancelation signal to be subtracted by a subtractor 346, 446 from the received signal in the receive chain.

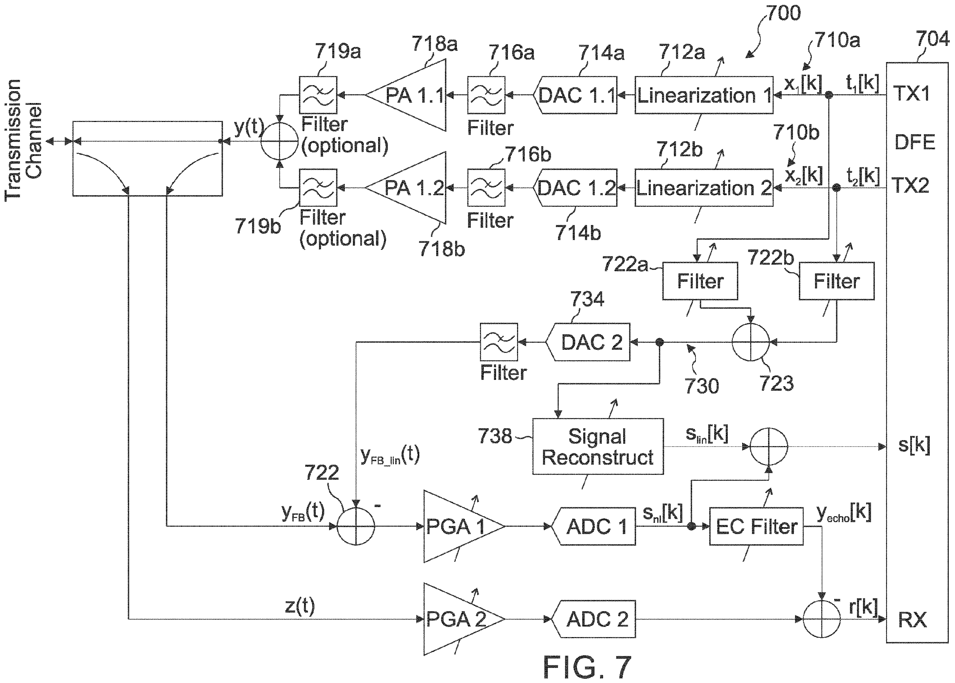

Fig. 7 shows an example system with multiple power amplifiers 718a, 718b and multiple transmit chains 710a, 710b. A system 700 may include more than one power amplifier 718a, 718b. It may be beneficial to have more than one power amplifier in certain systems, e.g. in a DOCSIS 3.1 FDX system at the cable modem side. In this case, the cable modem may transmit an upstream band with a relatively low power in a low frequency band and one or more bands with a higher power in a higher frequency band(s). The DOCSIS FDX standard allows less non-linear distortion in the low frequency band compared to the high frequency band. In this case, the system 700 may transmit the low and high frequency bands via separate power amplifiers 718a, 718b. As shown in Fig. 7, transmit filters 718a, 718b may be added at the power amplifier outputs to avoid that non-linear distortion generated by one of the power amplifiers 718a, 718b is transmitted inside the frequency bands transmitted by the other power amplifier(s) 718a, 718b. For example, the system 700 may include a high-pass filter (or a band-pass filter) at the output of the power amplifier that transmits the upper frequency band and/or a low-pass filter (or a band-pass filter) at the output of the power amplifier that transmits the lower frequency band. Fig. 7 shows a system 700 with two power amplifiers, but the system 700 may include more than two transmit chains and more than two power amplifiers. The extension to more than two power amplifiers is straightforward.

As in the system 300, the linear components of the transmit signals on the transmit chains 710a, 710b may be subtracted from the feedback signal in an analog domain. The transmit signals on the transmit chains 710a, 710b are fed to the corresponding filters 722a, 722b, respectively and the filter outputs are combined by an adder 723 and then fed to the DAC 734 for converting to an analog signal to be subtracted by a subtractor 722 (e.g. a coupler) from the feedback signal in an analog domain. Alternatively, the cancelation of the linear component of the transmit signal in the analog domain may be limited to the transmit signal with a higher or highest transmit power. Alternatively, the linear component of the transmit signal may be cancelled by using a band-stop filter as in the system 400.

In one example, a separate filter 722a, 722b may be used for each transmit signal, since the signals may be transmitted with different gains and with different transmit filters. In case of two or more transmit chains with separate power amplifiers 718a, 718b, filters 716a, 716b, DACs 714a, 714b, and/or linearization devices 712a, 712b, separate transmit signals may be generated at different rates by the DFE 704 and the linearization devices 712a, 712b and the DACs 714a, 714b may operate at different rates. Therefore, separate rate conversion blocks may be included to enable summing of the two transmit signals before they are fed to the DAC 734. The rate conversion blocks may be incorporated in the corresponding filters 722a, 722b.

With reference to Fig. 3, examples for training the filter 332 and the signal reconstruction filter 338 are explained hereafter. The same training algorithm may be used for training the filters in Figs. 4-7.

At initialization, the linearization device 312 is bypassed and the coefficients of the filter 332 are set to zero, which means that analog signal cancelation is disabled. The coefficients of the signal reconstruction filter 338 are also initialized with zeros. In order to avoid clipping at the ADC 326, the gain of the PGA 324 may be set to a small (appropriate) value. The gain of the PGA 324 is set such that the signal resolution at the ADC 326 is optimized.

To start training, the filter 332 is bypassed (or its coefficients are set accordingly) and a known signal is transmitted and the signals $x[k]$ and $s[k]$ are captured. For training the filter 332, in the frequency domain, the target transfer function of the filter 332 may be expressed as follows:

$$H_{EC1}(f) = \frac{H_{DAC1\_ADC1}(f)}{H_{DAC2\_ADC1}(f)},$$

where $H_{DAC1\_ADC1}(f)$ is the transfer function of the signal path between the DAC 314 and the ADC 326 and $H_{DAC2\_ADC1}(f)$ is the transfer function of the signal path between the DAC 334 and the ADC 326. For example, the individual transfer functions may be derived by transforming the corresponding impulse responses $h$ to the frequency domain by means of a discrete/fast Fourier transform. The impulse responses $h$ may be derived in the least squares sense, by calculating $h = R_{xx}^{-1} r_{xy}$, where $R_{xx}$ is the autocorrelation matrix of the training signal at the DAC 314 and the DAC 334, respectively, and $r_{xy}$ is the crosscorrelation vector between the training signal and the received signal at the ADC 326. Training can be simplified by disabling one of the two signal paths for each measurement, i.e. when estimating $H_{DAC1\_ADC1}(f)$ the signal received by the path with the transfer function $H_{DAC2\_ADC1}(f)$ is set to 0 (e.g. by disabling the DAC 334), and when estimating $H_{DAC2\_ADC1}(f)$ the signal received via $H_{DAC1\_ADC1}(f)$ is set to 0 (e.g. by disabling the DAC 314). If the filter 332 is realized as a finite impulse response (FIR) filter, the parameters may be derived from $H_{EC1}(f)$ by means of an inverse discrete/fast Fourier transform. The accuracy of this estimation needs to ensure that the signal attenuation is sufficient to increase the PGA gain by a reasonable amount. In practice, 20-30 dB of signal attenuation may be sufficient.

After configuring the filter 332 with the derived parameters, training of the PGA 324 may be performed. The coefficients of the filter 332 may then be scaled by the ratio of original and updated gain values of the PGA 324.

In a next step, the coefficients of the signal reconstruction filter 338 may be estimated. Since the output of the signal reconstruction filter 338 is required for training of the coefficients of the linearization device 312, they may be calculated with high accuracy.

If the system 300 comprises a filter 332 according to Fig. 3, then the signal reconstruction filter may mimic the impulse response between the filter 332 and the ADC 326. Training can be done by disabling the DAC 314, transmitting a known sequence and measuring the output signal of the ADC 326. Either the filter 332 may be bypassed or its parameters may be set to some known non-zeros values. The calculation of the impulse response may be performed by a least squares model. For example, this may be performed by feeding the filter 332 with a known training signal $x[k]$ and capturing the receive signal $y[k]$ at the ADC 326. The signal at the output of the filter 332 is denoted as $x_{EC1}[k]$. It can be calculated by convolving $x[k]$ with the impulse response of the filter 332 with the configured parameters. If the filter 332 is bypassed $x_{EC1}[k] = x[k]$.

The impulse response of length $N_{ECr}$ may be estimated in the least squares sense by solving the linear system of equations $h = -R_{x_{EC1}x_{EC1}}^{-1} r_{x_{EC1}y}$, where $R_{x_{EC1}x_{EC1}}$ is the autocorrelation matrix of the training signal $x_{EC1}[k]$ of size $N_{ECr} \times N_{ECr}$ and $r_{xEC1y}$ is the cross-correlation vector between the training signal $x_{EC1}[k]$ and the received signal at the ADC 326 of size $N_{ECr} \times 1$.

If the system comprises an analog band-stop filter in the feedback path 420 as shown in Fig. 4, the parameters of the signal reconstruction filter 438 may be calculated as follows. The signal reconstruction filter 438 may reconstruct the signal path from the DAC 414 to the ADC 426, where the path including the band-stop filter 422 needs to be reconstructed. Training may be performed in an efficient way if the band-stop filter 422 is implemented according to Fig. 5. The impulse response of this chain may be estimated by disabling the feedthrough pass by setting the signal 504 $tr = 1$. Once this is done, a known training signal $x[k]$ is transmitted at the DAC 414 and the receive signal $y[k]$ is captured at the output of the ADC 426. The impulse response of length $h_{ECr}$ may be estimated in the least squares sense by solving the linear system of equations $h = -R_{xx}^{-1} r_{xy}$, where $R_{xx}$ is the autocorrelation matrix of the training signal at the DAC 414 of size $N_{ECr} \times$

$N_{ECr}$ and $r_{xy}$ is the crosscorrelation vector between the training signal and the received signal at the ADC 426 of size $N_{ECr} \times 1$.

Assuming the signal reconstruction filter 338, 438 is implemented as an FIR filter, the estimated impulse response may be directly applied as a coefficient vector for the signal reconstruction filter 338, 438.

Referring to Fig. 3, once this is done, the coefficients of the linearization device 312 may be calculated by a state-of-the art algorithm. Depending on the underlying model that is used to implement the linearization device 312, the parameters may be approximated, for example, by solving a least squares parameter estimation problem or by applying a nonlinear adaptive training algorithm. Training of the linearization device 312 may need knowledge of the signal at the power amplifier output, which is reconstructed in the system 300 at the output of the adder 328 after the signal reconstruction filter 338. In Fig. 3, this signal is denoted as *s[k]*.

Since the non-linear distortion decreases after initial training of the linearization device 312, the gain of the PGA 324 may be further increased. The coefficients of the filter 332 may be scaled accordingly. The coefficients of all adaptive filters may be further adapted later on to increase the accuracy and to track changes of the environment over time.

Another example is a computer program having a program code for performing at least one of the methods described herein, when the computer program is executed on a computer, a processor, or a programmable hardware component. Another example is a machine-readable storage including machine readable instructions, when executed, to implement a method or realize an apparatus as described herein. A further example is a machine-readable medium including code, when executed, to cause a machine to perform any of the methods described herein.

The examples as described herein may be summarized as follows:

Example 1 is a system for power amplifier linearization. The system comprises a power amplifier configured to amplify a transmit signal, a linearization device configured to distort the transmit signal in a digital domain to linearize a transfer function of the power amplifier, a coupler for coupling the transmit signal to a transmit port, coupling a receive signal to a receive path, and coupling a portion of the transmit signal to a feedback path as a feedback signal, a signal cancelation system for canceling a linear component of the transmit signal from the feedback signal in an analog domain, a signal reconstruction filter for reconstructing the linear component of the transmit signal in a digital domain, and a combiner for combining the reconstructed linear component of the transmit signal with the feedback signal after canceling the linear component of the transmit signal in an analog domain. The parameters for the linearization device are generated based on an output of the combiner.

Example 2 is the system of example 1, wherein the signal cancelation system includes a linear filter for processing the transmit signal to generate the linear component of the transmit signal in a digital domain, a digital-to-analog converter for converting an output of the linear filter to an analog domain, and a subtractor for subtracting the linear component of the transmit signal from the feedback signal in the analog domain.

Example 3 is the system as in any one of examples 1-2, wherein the signal cancelation system includes a band-stop filter for removing the linear component of the transmit signal from the feedback signal in an analog domain.

Example 4 is the system of example 3, wherein the band-stop filter comprises a bandpass filter for passing a specific frequency band of signal from an input signal, a multiplexer for selectively outputting either the input signal or no signal depending on a control signal, and a subtractor for subtracting an output of the bandpass filter from an output of the multiplexer.

Example 5 is the system as in any one of examples 3-4, wherein the signal reconstruction filter generates the linear component of the transmit signal from the transmit signal in a digital domain.

Example 6 is the system as in any one of examples 1-5, further comprising an echo cancelation filter for generating an echo cancelation signal from the feedback signal after canceling the linear component of the transmit signal, and a subtractor for subtracting the echo cancelation signal from the receive signal in a digital domain.

Example 7 is the system as in any one of examples 1-6, further comprising an echo cancelation filter for generating an echo cancelation signal from the output of the combiner, and a subtractor for subtracting the echo cancelation signal from the receive signal in a digital domain.

Example 8 is the system as in any one of examples 1-6, further comprising a plurality of transmit chains, each transmit chain including a separate power amplifier for a transmit signal and a separate filter for filtering an output of each power amplifier.

Example 9 is the system of example 8, further comprising a plurality of linear filters, each linear filter for processing the transmit signal on each transmit chain to generate a linear component of the corresponding transmit signal, a combiner for combining outputs of the linear filters, a digital-to-analog converter for converting an output of the combiner to an analog domain, and a subtractor for subtracting the output of the digital-to-analog converter from the feedback signal in the analog domain.

Example 10 is the system of example 9, wherein a transmit signal with a highest transmit power is output from the combiner.

Example 11 is the system as in any one of examples 9-10, further comprising a rate conversion block for matching a data rate in transmit signals on the plurality of transmit chains.

Example 12 is a method for power amplifier linearization. The method comprises distorting a transmit signal in a digital domain to linearize a transfer function of a power amplifier, amplifying the transmit signal with the power amplifier, coupling a portion of the transmit signal to a feedback path as a feedback signal, canceling a linear component of the transmit signal from the feedback signal in an analog domain, reconstructing the linear component of the transmit signal in a digital domain, combining, by a combiner, the reconstructed linear component of the transmit signal with the feedback signal after canceling the linear component of the transmit signal in an analog domain, and generating parameters to linearize the power amplifier based on an output of the combiner.

Example 13 is the method of example 12, wherein a step of canceling the linear component of the transmit signal from the feedback signal comprises processing the transmit signal to generate a linear component of the transmit signal in a digital domain, converting the linear component of the transmit signal in the digital domain to an analog domain, and subtracting the linear component of the transmit signal from the feedback signal in the analog domain.

Example 14 is the method as in any one of examples 12-13, wherein the linear component of the transmit signal is canceled from the feedback signal by using a band-stop filter in an analog domain.

Example 15 is a device for power amplifier linearization. The device comprises a amplification means configured to amplify a transmit signal, a linearization means configured to distort the transmit signal in a digital domain to linearize a transfer function of the amplification means, a coupling means for coupling the transmit signal to a transmit port, coupling a receive signal to a receive path, and coupling a portion of the transmit signal to a feedback path as a feedback signal, a signal cancelation means for canceling a linear component of the transmit signal from the feedback signal in an analog domain, a signal reconstruction means for reconstructing the linear component of the transmit signal in a digital domain, and a combining means for combining the reconstructed linear component of the transmit signal with the feedback signal after canceling the linear component of the transmit signal in an analog domain. The parameters for the linearization means may be generated based on an output of the combiner.

Example 16 is the device of example 15, wherein the signal cancelation means includes a linear filter for processing the transmit signal to generate the linear component of the transmit signal in a digital domain, a digital-to-analog converter for converting an output of the linear filter to an analog domain, and a subtractor for subtracting the linear component of the transmit signal from the feedback signal in the analog domain.

Example 17 is the device as in any one of examples 15-16, wherein the signal cancelation means includes a band-stop filter for removing the linear component of the transmit signal from the feedback signal in an analog domain.

Example 18 is the system of example 17, wherein the band-stop filter comprises a bandpass filter for passing a specific frequency band of signal from an input signal, a multiplexer for selectively outputting either the input signal or no signal depending on a control signal, and a subtractor for subtracting an output of the bandpass filter from an output of the multiplexer.

Example 19 is the system as in any one of examples 17-18, wherein the signal reconstruction means generates the linear component of the transmit signal from the transmit signal in a digital domain.

Example 20 is the system as in any one of examples 15-19, further comprising an echo cancelation means for generating an echo cancelation signal from the feedback signal after canceling the linear component of the transmit signal, and a subtractor for subtracting the echo cancelation signal from the receive signal in a digital domain.

Example 21 is the system as in any one of examples 15-20, further comprising an echo cancelation means for generating an echo cancelation signal from the output of the combiner, and a subtracting means for subtracting the echo cancelation signal from the receive signal in a digital domain.

Example 22 is the system as in any one of examples 15-21, further comprising a plurality of transmit chains, each transmit chain including a separate power amplification means for a transmit signal and a separate filter for filtering an output of each power amplification means.

Example 23 is the system of example 22, further comprising a plurality of linear filters, each linear filter for processing the transmit signal on each transmit chain to generate a linear component of the corresponding transmit signal, a combiner for combining outputs of the linear filters, a digital-to-analog converter for converting an output of the combiner to an analog domain, and a subtractor for subtracting the output of the digital-to-analog converter from the feedback signal in the analog domain.

Example 24 is the system of example 23, wherein a transmit signal with a highest transmit power is output from the combiner.

Example 25 is the system as in any one of examples 23-24, further comprising a rate conversion means for matching a data rate in transmit signals on the plurality of transmit chains.

Example 26 is a machine-readable storage including machine readable instructions, when executed, to implement a method or realize an apparatus as in any one of preceding examples.

Example 27 is a computer program having a program code for performing a method as in any one of preceding examples, when the computer program is executed on a computer, a processor, or a programmable hardware component.

The aspects and features mentioned and described together with one or more of the previously detailed examples and figures, may as well be combined with one or more of the other examples in order to replace a like feature of the other example or in order to additionally introduce the feature to the other example.
Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.
The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.
A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.
Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.
A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.
It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A system for power amplifier linearization, comprising:

    a power amplifier (318, 418) configured to amplify a transmit signal;
    a digital-to-analog converter (314, 414) configured to convert the transmit signal to an analog domain, the transmit signal being amplified by the power amplifier (318, 418) after converting to the analog domain;
    a coupler (302) for coupling the transmit signal after amplifying by the power amplifier (318, 418) to a transmit port, coupling a receive signal to a receive path, and coupling a portion of the transmit signal after amplifying by the power amplifier (318, 418) to a feedback path as a feedback signal;
    a signal cancelation system for canceling a linear component of the transmit signal from the feedback signal in an analog domain;
    an analog-to-digital converter (326, 426) for converting the feedback signal after canceling the linear component of the transmit signal to a digital domain;
    an echo cancelation filter (329, 429) for generating an echo cancelation signal either from the feedback signal after canceling the linear component of the transmit; and
    a subtractor (346, 446) for subtracting the echo cancelation signal from the receive signal in a digital domain.

2. The system of claim 1, wherein the signal cancelation system includes:

    a linear filter (332) for processing the transmit signal to generate the linear component of the transmit signal in a digital domain;
    a digital-to-analog converter (334) for converting an output of the linear filter to an analog domain; and
    a subtractor (322) for subtracting the linear component of the transmit signal from the feedback signal in the analog domain.

3. The system of claim 1 or 2, wherein the signal cancelation system includes a band-stop filter (422) for removing the linear component of the transmit signal from the feedback signal in an analog domain.

4. The system of claim 3, wherein the band-stop filter (422) comprises:

    a bandpass filter (512) for passing a specific frequency band of signal from an input signal;
    a multiplexer (516) for selectively outputting either the input signal or no signal depending on a control signal; and
    a subtractor (514) for subtracting an output of the bandpass filter (512) from an output of the multiplexer (516).

5. The system of one of the previous claims, further comprising:
    a plurality of transmit chains (710a, 710b), each transmit chain (710a, 710b) including a separate power amplifier (718a, 718b) for a transmit signal and a separate filter (719a, 719b) for filtering an output of each power amplifier (718a, 718b).

6. The system of claim 5, wherein low and high frequency bands are transmitted via separate power amplifiers (718a, 718b).

7. The system of claim 5, wherein an upstream band with a relatively low power is transmitted in a low frequency band, and wherein one or more bands with a higher power is transmitted in a higher frequency band.

8. The system of claim 5 or 6, further comprising:

    a plurality of linear filters (722a, 722b), each linear filter (722a, 722b) for processing the transmit signal on each transmit chain (710a, 710b) to generate a linear component of the corresponding transmit signal;
    a combiner (723) for combining outputs of the linear filters (722a, 722b);
    a digital-to-analog converter (734) for converting an output of the combiner (723) to an analog domain; and
a subtractor (722) for subtracting the output of the digital-to-analog converter (734) from the feedback signal in the analog domain.

9. The system of claim 8, wherein a transmit signal with a highest transmit power is output from the combiner (723).

10. The system of claim 8 or 9, further comprising a rate conversion block for matching a data rate in transmit signals on the plurality of transmit chains (710a, 710b).

11. A method for power amplifier linearization, comprising:

distorting a transmit signal in a digital domain to linearize a transfer function of a power amplifier;
converting the transmit signal after being converted to an analog domain;
amplifying the transmit signal in the analog domain with the power amplifier;
coupling the transmit signal after amplifying by the power amplifier to a transmit port;
coupling a receive signal to a receive path;
coupling a portion of the transmit signal after amplifying by the power amplifier to a feedback path as a feedback signal;
canceling a linear component of the transmit signal from the feedback signal in an analog domain;
converting the feedback signal after cancelling the linear component of the transmit signal to a digital domain;
generating an echo cancelation signal either from the feedback signal after canceling the linear component of the transmit signal; and
subtracting the echo cancelation signal from the receive signal in a digital domain.

12. The method of claim 11, wherein a step of canceling the linear component of the transmit signal from the feedback signal comprises:

processing the transmit signal to generate a linear component of the transmit signal in a digital domain;
converting the linear component of the transmit signal in the digital domain to an analog domain; and
subtracting the linear component of the transmit signal from the feedback signal in the analog domain.

13. The method of claim 11 or 12, wherein the linear component of the transmit signal is canceled from the feedback signal by using a band-stop filter in an analog domain.

14. The method of claim 11, 12 or 13, further comprising:

transmitting an upstream band with a relatively low power in a low frequency band; and
transmitting one or more bands with a higher power in a higher frequency band.

15. A machine-readable storage medium including machine readable instructions which, when executed by a machine, cause the machine to carry out the method of any one of claims 11-14.

FIG. 1

FIG. 2

FIG. 3

EP 4 195 503 A1

FIG. 4

FIG. 5

FIG. 6

FIG. 7

EP 4 195 503 A1

Europäisches
Patentamt

European
Patent Office

Office européen
des brevets

## EUROPEAN SEARCH REPORT

Application Number

EP 23 15 0187

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LIU YING ET AL: "Novel Linearization Architecture with Limited ADC Dynamic Range for Green Power Amplifiers", IEEE JOURNAL ON SELECTED AREAS IN COMMUNICATIONS, IEEE SERVICE CENTER, PISCATAWAY, US, vol. 34, no. 12, 1 December 2016 (2016-12-01), pages 3902-3914, XP011638294, ISSN: 0733-8716, DOI: 10.1109/JSAC.2016.2600415 [retrieved on 2016-12-29] * figure 2 * * paragraph III.A Signal Cancellation * * paragraph III.B Signal Reconstruction *  ----- | 1-15 | INV. H03F1/32 H03F3/24 H04B3/23 H03F3/189 H03F3/21 |
| A | US 2014/161005 A1 (LAURENT-MICHEL STEPHANE [US]) 12 June 2014 (2014-06-12) * figure 10 * * paragraph [0012] – paragraph [0014] * * paragraph [0062] – paragraph [0066] * * paragraph [0051] *  ----- | 1-15 | |
| A | GB 2 553 183 A (CISCO TECH INC [US]) 28 February 2018 (2018-02-28) * figure 5 * * paragraph [0052] * * paragraph [0064] – paragraph [0068] *  ----- | 1-15 | TECHNICAL FIELDS SEARCHED (IPC) H03F H04B |

The present search report has been drawn up for all claims

| Place of search | Date of completion of the search | Examiner |
|---|---|---|
| The Hague | 13 February 2023 | Gimmler-Dumont, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

        .................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 0187

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2023

| Patent document cited in search report | Publication date | Patent family member(s) | Publication date |
|---|---|---|---|
| US 2014161005 A1 | 12-06-2014 | US 2014161005 A1<br>US 2016020859 A1<br>WO 2014078455 A1 | 12-06-2014<br>21-01-2016<br>22-05-2014 |
| GB 2553183 A | 28-02-2018 | NONE | |

EPO FORM P0459

For more details about this annex : see Official Journal of the European Patent Office, No. 12/82